# EUROPÄISCHE PATENTSCHRIFT

(11) **EP 1 198 695 B1**
(45) Veröffentlichungstag und Bekanntmachung des Hinweises auf die Patenterteilung: **16.03.2005**
(21) Anmeldenummer: 00951413.4
(22) Anmeldetag: 20.07.2000
(51) Int. Cl.: G01C 19/56, G01P 15/08

(54) **VERFAHREN ZUR HERSTELLUNG EINER TORSIONSFEDER**
METHOD FOR PRODUCING A TORSION SPRING
PROCEDE DE PRODUCTION D'UN RESSORT A TORSION

(30) Priorität: 21.07.1999 DE 19934174
(43) Veröffentlichungstag der Anmeldung: 24.04.2002
(73) Patentinhaber: LITEF GmbH, 79115 Freiburg (DE)
(72) Erfinder: WIEMER, Maik, D-09212 Limbach Oberfrohna (DE); HILLER, Karla, D-08294 Lössnitz (DE); BILLEP, Detlef, D-09119 Chemnitz (DE); BRENG, Uwe, D-79194 Gundelfingen (DE); RYRKO, Bruno, D-79276 Reute (DE); HANDRICH, Eberhard, D-79199 Kirchzarten (DE)
(74) Vertreter: Müller, Frithjof E., Dipl.-Ing.
(86) Internationale Anmeldenummer: PCT/EP2000/006957
(87) Internationale Veröffentlichungsnummer: WO 2001/007869

(56) Entgegenhaltungen:
- WO-A-96/38710
- DE-A- 2 818 106
- DE-A- 4 126 100

## Beschreibung

Die Erfindung betrifft ein Verfahren nach dem Oberberiff des Patentanspruchs 1 zur Herstellung einer Torsionsfeder als Teil eines aus zwei Wafern oder zwei Waferverbunden herzustellenden mikromechanischen Torsionsfeder-Masse-Systems mit niedriger Torsionssteifigkeit im Vergleich zur Quersteifigkeit in lateraler und vertikaler Richtung.

Aus DE 41 26 100 A1 sind Torsionsfederbänder mit dreieck-, trapez- oder V-förmigem Querschnitt zur integrierten Aufhängung eines mikromechanischen Drehbeschleunigungssensors bekannt. Zumindest die V-förmigen Querschnitte werden dabei an zwei gegenüberstehenden seitlichen Randbereichen eines Wafers bzw. Waververbunds durch anisotropisches nasschemisches Ätzen als eine sich über die gesamte Wafer- oder Waferverbunddicke erstreckende Feder mit lateral durch [111]-Flächen begrenztem V-Querschnitt erzeugt. Bei dieser Art der Aufhängung einer schwingungsfähigen Masse führen jedoch lineare Beschleunigungen in der Waferebene zu Auslenkungen und damit zu Fehlmessungen, weil die Quersteifigkeit der Aufhängung zu gering ist.

Aus DE 28 18 106 A1 ist auch eine Torsionsfeder bekannt, die aufgrund eines kreuzförmigen Querschnitts eine im Vergleich zur Quersteifigkeit in lateraler und vertikaler Richtung niedrige Torsionssteifigkeit aufweist.

Journal of Microelectromechanical Systems (Vol. 6, No. 2, June 1997, pp. 119 - 125) offenbart eine auch als Torsionsfeder wirksame Röhre eines Sensors. Diese Röhre wird nach dem Coriolis-Prinzip durch Drehen, spiegelbildliche Aufeinanderlegung und Verbonden von Wafern mit einem darin jeweils gebildeten Graben hergestellt.

Als weiteres Beispiel für eine Anwendung solcher Torsionsfedern sei auf Drehspiegel und mikromechanische Drehratensensoren hingewiesen, wie sie in der internationalen Patentanmeldung WO 96/38710 beschrieben sind. Insbesondere die Figur 8 der genannten Druckschrift zeigt eine doppellagige Schwingerstruktur, die über ein aus den Waferschichten geformtes Kreuzfedergelenk in einem Rahmen gehalten ist. Dieses aus insgesamt vier einzelnen Federelementen gebildete Kreuzfedergelenk verbessert die erwünschte Steifigkeit in den Waferebenen, worauf in der genannten WO-Druckschrift hingewiesen ist.

Für eine derartige Schwingerstruktur, deren plattenförmig übereinander angeordnete Schwinger einen auf dem Coriolis-Prinzip basierenden mikromechanischen Drehratensensor bilden, ist es jedoch wünschenswert, das genannte Kreuzfedergelenk zu optimieren und zwar so, dass sich im Vergleich zur Torsionssteifigkeit eine möglichst hohe Quersteifigkeit in Richtung der Waferebenen beziehungsweise senkrecht dazu, das heißt also in lateraler und vertikaler Richtung ergibt.

Der Erfindung liegt damit die Aufgabe zugrunde, für ein mikromechanisches Torsionsfeder-Masse-System ein Verfahren zur Herstellung einer optimierten Torsionsfeder anzugeben.

Silicium-Torsionsfedern in Mikrostrukturierung sind in verschiedenen Ausführungsvarianten bereits bekannt. So beschreibt der Fachaufsatz in Lit. [1] relativ lange schmale Bänder, beispielsweise zum Anlenken von Torsionsspiegeln. Der Federquerschnitt ist trapezförmig. Die Federn sind an gegenüberliegenden Waferränden ausgebildet und werden durch Ätzen von Gruben von der Rückseite bei Strukturierung der Federn von der Vorderseite hergestellt. Lit. [2] beschreibt die Herstellung eines rechteckförmigen Torsionsquerschnitts, insbesondere für die Aufhängung eines Stimmgabelresonators mit relativ hohem Aspektverhältnis (Höhe: Breite ≥ 4), wobei als Herstellungsverfahren tiefes RIE-Ätzen (Reactive Ion Etching) vorgeschlagen wird. Diese beiden Torsionsfederquerschnitte haben den Nachteil, daß sie auch empfindlich gegenüber Querbeanspruchungen sind. Der nach dem ersteren Verfahren hergestellte Federquerschnitt ist besonders gegenüber vertikaler Biegung und der nach dem letzteren Verfahren hergestellte Federquerschnitt besonders gegenüber lateraler Biegung empfindlich.

Die Erfindung ist bei einem Verfahren zur Herstellung einer Torsionsfeder als Teil eines aus zwei Wafern oder Waferverbunde herzustellenden mikromechanischen Torsionsfeder-Masse Systems mit niedriger Torsionssteifigkeit im Vergleich zur Quersteifigkeit in lateraler und/oder vertikaler Richtung dadurch gekennzeichnet, daß an mindestens einem Rand jedes Wafers beziehungsweise Waferverbunds durch anisotropes naßchemisches Ätzen eines sich über die gesamte Wafer- oder Waferverbunddicke erstreckende Feder mit lateral nur durch [111]-Flächen begrenztem V-förmigen Querschnitt erzeugt wird. und daß die beiden so vorstrukturierten Wafer beziehungsweise Waferverbunde um 180° gedreht und spiegelbildlich aufeinander ausgerichtet miteinander verbondet werden, so daß im Bereich der beiden V-förmigen Federquerschnitte ein insgesamt X-förmiger Torsionsfederquerschnitt gebildet wird.

Wird die Erfindung in Verbindung mit der Herstellung der genannten mikromechanischen Drehratensensoren angewendet, so wird - um unterschiedliche Anregungspotentiale beziehungsweise Rückstellsignale einerseits und Zu- und Auslesepotentiale andererseits nach außen abführen zu können - für jeweils einen der Plattenschwinger von einem vorzugsweise zweilagigen Waferverbund ausgegangen. Um beispielsweise vier verschiedene elektrische Potentiale über die gekreuzten Federn der nach dem erfindungsgemäßen Verfahren hergestellten Torsionsfedern zu- oder abführen zu können, ist es vorteilhaft, auf mindestens einem der Wafer beziehungsweise dem Waferverbund auf der dem anderen Wafer beziehungsweise anderen Waferverbund beim Verbonden zugekehrten Oberfläche ein isolierendes Oxid aus auszubilden.

Durch den aufgrund des Verfahrens entstandenen X-förmigen. integral-verbundenen Torsionsfederquerschnitt erhöht sich das Verhältnis von Quersteifigkeit zu Torsionssteifigkeit gegenüber einem Rechteckquerschnitt, aber auch gegenüber einzelnen gekreuzten Federelementen, wie sie in der genannten WO-Druckschrift veranschaulicht sind, um mehr als zwei Größenordnungen.

Ein besonderer Vorteil des erfindungsgemäßen Verfahrens ist in der einfachen Technologie zu sehen, da die Torsionsfeder nicht durch zeitabhängige Ätzprozesse beeinflußt ist, so daß insgesamt bei der Kombination der beiden V-förmigen Federn nur ein zeitkritischer Ätzschritt auftritt.

Die Maßhaltigkeit der Torsionsfeder, deren Masken ersichtlicherweise lange schmale Strukturen enthält, hängt unter anderem von einer exakten Übereinstimmung zwischen der Kristallrichtung (110) und der jeweiligen Maskenausrichtung ab. Um dies zu gewährleisten, wird mit der Erfindung zur exakten Ausrichtung der Wafer untereinander beziehungsweise von Wafern zu Masken die Justagereferenz für das Verbonden, insbesondere Silizium-Direkt-Bonden. und die Lithographie mit geeigneten chemischen, plasmachemischen und/oder mechanischen Mitteln nach der (110)-Kristallrichtung ausgerichtet. Diese Ausrichtung kann zum Beispiel dadurch erfolgen, daß die Wafer zunächst mit einer Ätzmaske versehen werden. welche parallel zur angeschliffenen Phase einer Maskenkante erzeugt wird. Anschließend werden die Wafer mit dieser Maske anisotrop überätzt, wodurch eine neue Referenzenphase entsteht, die anschließend als optische beziehungsweise mechanische, vorzugsweise gravitationsunterstützte Justagereferenz für das Silizium-Direkt-Bonden und die Litografie, also die Maskenausrichtung benutzt wird.

Die Erfindung wird nachfolgend anhand zweier Ausführungsbeispiele näher erläutert. Es zeigen:
- **Fig. 1**: eine erste erfindungsgemäße Verfahrensvariante zur Herstellung einer Tosionsfeder mit X-förmigen Querschnitt aus zwei Wafern, und
- **Fig. 2**: eine zweite abgewandelte Verfahrensführung.

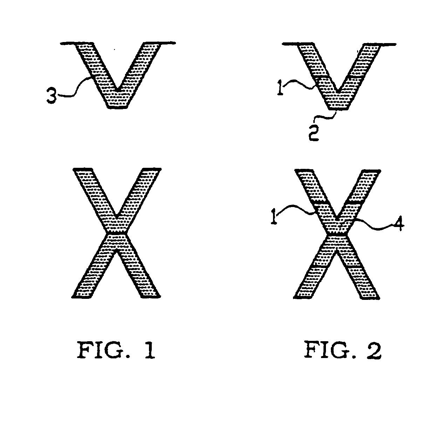

Ausgangspunkt des Herstellungsverfahrens sind im Falle der Figur 1 zwei gleichartige Wafer und im Falle der Figur 2 zwei Waferschichtverbunde. die entlang ihrer gemeinsamen Oberflächenebene durch eine Isolationsoxidschicht 1 voneinander getrennt beziehungsweise gegeneinander elektrisch isoliert sind, mit einer Schichtdicke von beispielsweise bis zu 4 µm. Im seitlichen Randbereich der Wafer beziehungsweise des Waferverbunds werden streifenförmige Ätzmasken 2 aufgebracht. Sodann wird durch anisotropisches, naßchemisches Ätzen im Randbereich jedes Wafers beziehungsweise Waferverbunds eine Feder 3 mit V-förmigen Querschnitt erzeugt, die lateral durch [111]-Flächen begrenzt ist. Anschließend werden zwei der so mit V-förmiger Feder vorstrukturierte Wafer beziehungsweise Waferverbunde um 180° gegeneinander gedreht und spiegelbildlich aufeinander ausgerichtet miteinander verbondet, insbesondere durch Silizium-Direkt-Bonden, so daß die erwünschte quersteife Torsionsfeder mit X-förmigen Querschnitt als Aufhängeelement für eine einheitliche Torsionsfeder-Masse-Systemstruktur gebildet ist.

### Literaturliste zum Stand der Technik

- Lit. [1]: C. Kaufmann. J. Markert. T. Werner, T. Geßner. W. Dötzel: Charakterisierung von Material- und Strukturdefekten an mikromechanischen Scannern mittels Frequenzanalyse, Proceedings of Micro Materials '95, S. 443
- Lit. [2]: J. Choi, K. Minami, M. Esahi: Silicon Angular Rate Sensor by Deep Reactive Ion Etching, Proc. of the Int. Symposium on Microsystems, Intelligent Materials and Robots, 1995, Sendal, Japan, S. 29-32

## Patentansprüche

1. Verfahren zum Herstellen einer Torsionsfeder als Teil eines aus zwei Wafern oder zwei Waferverbunden zu gewinnenden mikromechanischen Torsionsfeder-Masse-Systems mit niedriger Torsionssteifigkeit im Vergleich zur Quersteifigkeit in lateraler und vertikaler Richtung, bei dem an mindestens einem seitlichen Randbereich jedes Wafers beziehungsweise Waferverbunds durch anisotropes naßchemisches Ätzen eine sich über die gesamte Waferoder Waferverbunddicke erstreckende Feder (3) mit lateral durch [111]-Flächen begrenztem V-förmigen Querschnitt erzeugt wird, **dadurch gekennzeichnet, dass** die beiden so vorstrukturierten Wafer beziehungsweise Waferverbunde um 180° gedreht und spiegelbildlich aufeinander ausgerichtet miteinander verbondet werden, so daß im Bereich der beiden V-förmigen Federquerschnitte ein insgesamt X-förmiger, integral-verbundener Torsionsfederquerschnitt gebildet wird.

2. Verfahren nach Anspruch 1, **dadurch gekennzeichnet, dass** auf mindestens dem einen Wafer beziehungsweise Waferverbund auf der dem anderen Wafer beziehungsweise Waferverbund beim Verbonden zugekehrten Oberfläche ein isolierendes Oxid (4) ausgebildet wird.

3. Verfahren nach Anspruch 2, **dadurch gekennzeichnet, dass** die beiden Wafer beziehungsweise Waferverbunde durch Silizium-Direkt-Bonden miteinander verbunden werden.

## Claims

1. A method for producing a torsion spring as part of a micromechanical torsion spring/mass system, which can be obtained from two wafers or two wafer composites, and has a low torsional stiffness compared to the transverse stiffness in the lateral and vertical directions, wherein a spring (3) which extends over the entire wafer or wafer composite thickness and has a V-shaped cross section which is laterally delimited by [111] surfaces, is produced on at least one side edge region of each wafer or wafer composite by anisotropic wet-chemical etching, **characterized in that** the two wafers or wafer composites which have been prestructured in this way are rotated through 180° and are bonded to one another oriented in a mirror-symmetrical fashion with respect to one another, so that overall an X-shaped integrally joined torsion spring cross section is formed in the region of the two V-shaped spring cross sections.

2. The method as claimed in claim 1. **characterized in that**, on at least one wafer or wafer composite, an insulating oxide (4) is formed on the surface which faces the other wafer or wafer composite during bonding.

3. The method as claimed in claim 2, **characterized in that** the two wafers or wafer composites are joined to one another by silicon direct bonding.

## Revendications

1. Procédé pour la fabrication d'un ressort à torsion comme partie d'un système ressort à torsion-masse micromécanique, à produire à partir de deux tranches ou de deux assemblages de tranches, avec une faible rigidité de torsion par rapport à la rigidité transversale dans la direction latérale et la direction verticale, dans lequel un ressort (3) s'étendant sur l'ensemble de l'épaisseur de la tranche ou épaisseur de l'assemblage de tranches avec une section en forme de V délimitée latéralement par les surfaces [111] est fabriqué sur au moins une zone périphérique latérale de chaque tranche ou d'assemblage de tranches par décapage chimique par voie humide et anisotrope, **caractérisé en ce que** les deux tranches ou assemblages de tranches ainsi préstructurés sont tournés de 180 ° et sont bondérisés entre eux et orientés de façon symétrique l'un par rapport à l'autre, de sorte que, dans la zone des deux sections de ressort en forme U, on forme une section de ressort à torsion globalement en forme de X et reliée de façon intégrale.

2. Procédé selon la revendication 1, **caractérisé en ce qu'**un oxyde (4) isolant est formé sur au moins une tranche ou un assemblage de tranches sur la surface tournée vers l'autre tranche ou l'autre assemblage de tranches lors de la bondérisation.

3. Procédé selon la revendication 2, **caractérisé en ce que** les deux tranches ou assemblages de tranches sont reliés entre elles ou entre eux par bondérisation directe de silicium.
